# FASCICULE DE BREVET EUROPEEN

(11) **EP 4 386 815 B1**
(45) Date de publication et mention de la délivrance du brevet: **12.11.2025**
(21) Numéro de dépôt: 23215728.9
(22) Date de dépôt: 12.12.2023
(51) Int. Cl.: H10D 30/01, H10D 30/60, H10D 64/68, H01L 21/268, H01L 21/28

(54) **PROCÉDÉ DE FABRICATION D'UN TRANSISTOR À EFFET DE CHAMP À CANAL SIGE**
VERFAHREN ZUR HERSTELLUNG EINES SIGE-KANAL-FELDEFFEKTTRANSISTORS
METHOD OF FABRICATING A SIGE CHANNEL FIELD EFFECT TRANSISTOR

(30) Priorité: 13.12.2022 FR 2213226
(43) Date de publication de la demande: 19.06.2024
(73) Titulaire: Commissariat à l'Energie Atomique et aux Energies Alternatives, 75015 Paris (FR)
(72) Inventeur: ACOSTA ALBA, Pablo, 38054 GRENOBLE CEDEX 09 (FR); FENOUILLET-BERANGER, Claire, 38054 GRENOBLE CEDEX 09 (FR); GASSILLOUD, Rémy, 38054 GRENOBLE CEDEX 09 (FR); KERDILES, Sébastien, 38054 GRENOBLE CEDEX 09 (FR); REBOH, Shay, 38054 GRENOBLE CEDEX 09 (FR)
(74) Mandataire: Cabinet Camus Lebkiri

(56) Documents cités:
- US-A1- 2021 119 032
- US-B1- 6 743 680
- HUET K ET AL: "Pulsed laser annealing for advanced technology nodes: Modeling and calibration", APPLIED SURFACE SCIENCE, ELSEVIER, AMSTERDAM , NL, vol. 505, 23 November 2019 (2019-11-23), XP085991294, ISSN: 0169-4332, [retrieved on 20191123], DOI: 10.1016/J.APSUSC.2019.144470

## Description

### DOMAINE TECHNIQUE

La présente invention est relative aux techniques de fabrication des transistors à effet de champ (ou **FET,** pour « Field Effect Transistor » en anglais). L'invention concerne plus particulièrement un procédé de fabrication d'un transistor à effet de champ à canal SiGe.

### ÉTAT DE LA TECHNIQUE

L'une des architectures CMOS (« Complementary Metal-Oxide-Semiconductor » en anglais) les plus prometteuses pour les nœuds technologiques actuels et futurs consiste à utiliser des canaux en silicium (Si) pour les transistors à effet de champ de type NMOS et des canaux en silicium-germanium (SiGe) pour les transistors à effet de champ de type PMOS. L'utilisation de canaux en SiGe pour les transistors PMOS est connue pour améliorer la mobilité des porteurs de charge (trous) et diminuer la tension de seuil des transistors par rapport au silicium seul. Une forte concentration en germanium (typiquement supérieure à 20 %) est généralement recherchée, étant donné que la mobilité des porteurs de charge augmente avec la concentration en germanium. Pour améliorer encore la mobilité des porteurs de charge, les canaux en Si peuvent être contraint en tension et les canaux en SiGe peuvent être contraint en compression.

La réalisation d'une structure de grille fiable sur une couche de SiGe ayant une forte concentration en germanium est cependant délicate. En particulier, l'oxydation thermique d'une telle couche conduit à la croissance d'un oxyde de type GeOₓ de mauvaise qualité électrique. Plus précisément, le mélange d'oxyde de silicium (SiOₓ) et d'oxyde de germanium (GeOx) génère un nombre plus important de défauts d'interface par rapport à un oxyde de silicium pur, ce qui conduit à un piégeage plus important des porteurs de charge et donc à une diminution des performances des transistors PMOS. La concentration de GeOₓ dans la couche d'oxyde est environ égale à celle du germanium dans la couche de SiGe et devient problématique au-delà de 10 %.

Le document US2018/076040 décrit un procédé de fabrication d'un transistor à effet de champ comprenant une couche d'interface en oxyde de silicium disposée entre une région de canal en SiGe et une couche de matériau diélectrique à constante diélectrique élevée (matériau diélectrique dit « high-k »). Le procédé de fabrication comprend une étape de croissance d'une couche active en SiGe (concentration en germanium comprise entre 20 % et 70 %) à la surface d'un substrat, une étape de formation d'une couche d'oxynitrure de silicium (SiON) à la surface de la couche active au moyen d'un premier procédé d'oxynitruration, une étape de retrait de la couche de SiON et une étape de formation de la couche d'interface en oxyde de silicium « pur » ou SiO₂ au moyen d'un deuxième procédé d'oxynitruration. Le deuxième procédé d'oxynitruration est identique ou sensiblement identique au premier procédé d'oxynitruration. Le premier procédé d'oxynitruration traite la surface de la couche active en SiGe de manière à empêcher la formation de l'oxyde GeOₓ et l'introduction d'azote dans la couche d'interface en oxyde de silicium formée lors du deuxième procédé d'oxynitruration. Ainsi, la couche d'interface en oxyde de silicium est pratiquement dépourvue d'azote et de GeOx.

Ce procédé de fabrication permet d'obtenir une couche d'oxyde de grille (en SiO₂) de haute qualité sur une couche de SiGe de forte concentration en germanium. Il est toutefois long à mettre en œuvre. En outre, il peut consommer du silicium dans le cas d'un substrat de type silicium sur isolant (ou SOI, pour « Silicon On Insulator ») à faible épaisseur de canal (pour former des transistors de type FDSOI). Enfin, les procédé d'oxynitruration sont accomplis à des températures comprises entre 600°C et 800°C, ce qui n'est pas compatible avec la fabrication d'un niveau supérieur de transistors, réalisée à basse température (<500°C) pour ne pas endommager les transistors précédemment réalisés dans un niveau inférieur.

Par ailleurs, le document [« Investigation of recrystallization and stress relaxation in nanosecond laser annealed Si₁₋ₓGeₓ/Si epilayers » ; L. Dagault et al ; Applied Surface Science, Volume 527, 2020] décrit une couche de SiGe formée par épitaxie sur un substrat en silicium, puis soumise à un recuit laser nanoseconde (ou NLA, pour Nanosecond Laser Annealing » en anglais). Le recuit laser nanoseconde entraîne une fusion au moins partielle de la couche de SiGe. Une redistribution des atomes de germanium est observée lors de la recristallisation de la couche de SiGe. Les atomes de germanium sont « aspirés » vers la surface de la couche de SiGe, du fait d'un mécanisme de ségrégation. Il en résulte un gradient de concentration en germanium dans l'épaisseur de la couche de SiGe. Cette technique peut être utilisée pour diminuer la résistivité électrique des contacts de source et de drain dans les transistors PMOS (régions de source et de drain en SiGe). Le document US2021119032 A1 divulgue un procédé de fabrication d'un transistor à effet de champ comprenant une couche active en silicium-germanium et une couche d'oxyde de grille disposée sur la couche active, le procédé comprenant les étapes de fournir un empilement comprenant un substrat, une première couche en silicium-germanium disposée sur le substrat et une deuxième couche en silicium disposée sur la première couche, de former la couche d'oxyde de grille sur l'empilement et de soumettre l'empilement à un recuit laser de manière à fondre une région de l'empilement, ladite région comprenant une partie au moins de la première couche, et recristalliser la région fondue de l'empilement pour obtenir la couche active en silicium-germanium en contact avec la couche d'oxyde de grille, la couche active présentant un gradient de concentration en germanium.

### RESUMÉ DE L'INVENTION

On constate qu'il existe un besoin de fabriquer un transistor à effet de champ à canal SiGe performant de façon plus simple et plus rapide.

Selon l'invention, on tend à satisfaire ce besoin en prévoyant un procédé de fabrication d'un transistor à effet de champ comprenant une couche active en silicium-germanium et une couche d'oxyde de grille disposée sur la couche active, le procédé comprenant les étapes définies dans la revendication 1.

L'étape de recuit laser permet de concentrer les atomes de germanium à l'interface avec la couche d'oxyde de grille, sans pour autant endommager cette dernière. Ainsi, dans ce procédé de fabrication, le gradient de concentration en germanium de la couche active est obtenu après formation de l'oxyde de grille (ou en même temps), et non pas avant (pendant l'étape de croissance par épitaxie par exemple).

Selon l'invention, l'empilement comprend une deuxième couche en silicium disposée sur la première couche et ladite région comprend une partie au moins de la deuxième couche.

Selon un développement de ce premier mode de mise en œuvre, la couche d'oxyde de grille peut être formée par oxydation thermique ou chimique d'une portion au moins de la deuxième couche ou par exposition de la deuxième couche à un plasma contenant de l'oxygène.

La deuxième couche en silicium présente avantageusement une épaisseur comprise entre 0,2 nm et 15 nm, de préférence entre 0,8 nm et 6 nm.

De préférence, la première couche en silicium-germanium présente une concentration en germanium comprise entre 1 % et 80 %, avantageusement entre 10 % et 60 %.

La couche d'oxyde de grille peut être constituée de dioxyde de silicium et présenter une épaisseur comprise entre 0,5 nm et 6 nm.

Dans un deuxième mode de mise en œuvre, la première couche en silicium-germanium présente une concentration en germanium comprise entre 5 % et 10 %.

Selon un autre développement, la couche d'oxyde de grille comprend du dioxyde de silicium et de l'oxyde de germanium, le pourcentage d'oxyde de germanium étant inférieur ou égal à 10 %, et la couche d'oxyde de grille présente une épaisseur comprise entre 0,5 nm et 6 nm.

Le procédé de fabrication selon l'invention peut également présenter une ou plusieurs des caractéristiques ci-dessous, considérées individuellement ou selon toutes les combinaisons techniquement possibles :
- la région fondue de l'empilement s'étend jusqu'à la couche d'oxyde de grille ;
- la couche d'oxyde de grille est formée de manière à présenter un pourcentage d'oxyde de germanium (GeOₓ) inférieur ou égal à 10 % ;
- le procédé comprend en outre une étape de dépôt d'une couche de matériau diélectrique à constante diélectrique élevée sur la couche d'oxyde de grille ;
- la couche de matériau diélectrique à constante diélectrique élevée est formée avant ou après l'étape de recuit laser ;
- le recuit laser est accompli en exposant l'empilement à un rayonnement laser présentant une longueur d'onde comprise entre 200 nm et 600 nm et une densité d'énergie comprise entre 0,1 J/cm² et 10 J/cm² pendant une durée comprise entre 10 ns et 1000 ns ;
- le recuit laser est accompli sous une atmosphère dépourvue d'oxygène ;
- le recuit laser est accompli sous une atmosphère contenant de l'oxygène pour former simultanément la couche d'oxyde de grille ;
- le procédé comprend en outre une étape de formation d'une électrode de grille sur la couche d'oxyde de grille ;
- le procédé comprend en outre une étape de formation de régions de source et de drain ; et
- le transistor comprend une région de canal formé par la couche active et des régions de source et de drain disposées de part et d'autre de la région de canal.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes.
- la figure 1 représente schématiquement un transistor à effet de champ à canal SiGe ;
- les figures 2A à 2C représentent un premier mode de mise en œuvre du procédé de fabrication de transistor à effet de champ selon l'invention ; et
- les figures 3A à 3C représentent un deuxième mode de mise en œuvre du procédé de fabrication de transistor à effet de champ non couvert par l'invention revendiquée.

Pour plus de clarté, les éléments identiques ou similaires sont repérés par des signes de référence identiques sur l'ensemble des figures.

### DESCRIPTION DÉTAILLÉE

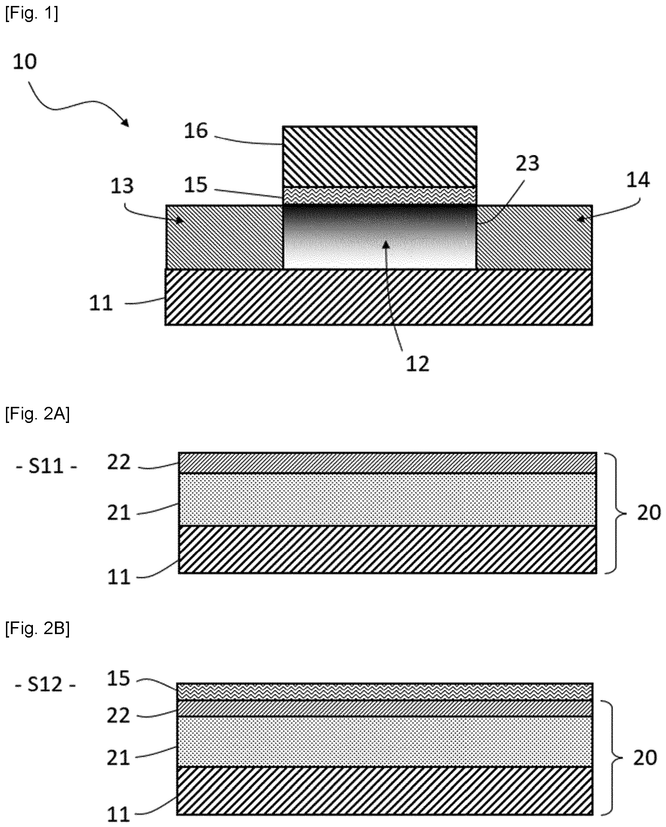

La figure 1 est une vue en coupe schématique d'un transistor à effet de champ 10 à canal SiGe. Le transistor à effet de champ 10 comprend un substrat 11, une région de canal 12 disposée sur le substrat 11, des régions de drain et de source 13-14 disposées sur le substrat 11 de part et d'autre de la région de canal 12, une couche d'oxyde de grille 15 disposée sur la région de canal 12 et une électrode de grille 16 disposée sur la couche d'oxyde de grille 15. L'électrode de grille 16 est séparée de la région de canal 12 par la couche d'oxyde de grille 15.

Le transistor à effet de champ 10 est avantageusement de type PMOS. Les régions de drain et de source 13-14 sont alors des régions semi-conductrices dopées de type P.

La région de canal 12 comprend une couche active 23 en silicium-germanium (SiGe), en contact avec la couche d'oxyde de grille 15. Cette couche active 23 en SiGe peut être contrainte en compression ou au contraire relâchée, c'est-à-dire soumise à aucune contrainte en tension ou en compression. Elle présente dans son épaisseur un gradient de concentration en germanium. De préférence, la concentration en germanium augmente en se rapprochant de l'interface entre la couche active 23 et la couche d'oxyde de grille 15 et atteint une valeur maximale à cette interface. La valeur maximale de la concentration en germanium est avantageusement comprise entre 30 % et 80 % (en pourcentage atomique) pour conférer une forte mobilité aux porteurs de charge électrique dans la région de canal 12 et diminuer la tension de seuil du transistor. La couche d'oxyde de grille 15 présente de préférence une épaisseur comprise entre 0,5 nm et 6 nm.

Le transistor à effet de champ 10 peut également comprendre une couche de matériau diélectrique à forte constante diélectrique (non représentée) disposée entre la couche d'oxyde de grille 15 et l'électrode de grille 16. Un matériau diélectrique à forte constante diélectrique (matériau diélectrique dit « high-k ») désigne un matériau ayant une constante diélectrique k supérieure à la constante diélectrique du dioxyde de silicium (SiO₂), soit supérieure à 3,9.

Les figures 2A à 2C représentent des étapes S11 à S13 d'un procédé de fabrication du transistor à effet de champ 10, selon un premier mode de mise en œuvre de l'invention. Ces étapes sont relatives à la formation de la couche active 23 en SiGe (formant la région de canal 12) et de la couche d'oxyde de grille 15.

L'étape S11 de la figure 2A consiste à fournir un empilement 20 comprenant le substrat 11, une première couche 21 en SiGe disposée sur le substrat 11 et une deuxième couche 22 en silicium disposée sur la première couche 21.

Le substrat 11 peut être un substrat massif (« bulk » en anglais) en un matériau semiconducteur (par exemple en silicium, germanium, silicium-germanium ou carbure de silicium) ou un substrat de type silicium sur isolant (ou SOI, pour « Silicon On Insulator).

La première couche 21 en SiGe est de préférence formée par épitaxie sur une face du substrat 11. La première couche 21 en SiGe présente avantageusement une concentration en germanium (aussi appelée pourcentage atomique de germanium) comprise entre 1 % et 80 %, préférentiellement entre 5 % et 60 % et encore plus préférentiellement entre 10% et 60%. Plus le pourcentage de germanium est élevé, plus le nombre de défauts pouvant capturer des trous accumulés dans le film de SiGe est réduit.

L'épaisseur de la première couche 21 en SiGe peut être comprise entre 5 nm et 50 nm. De préférence, la première couche 21 en SiGe ne présente pas de gradient de concentration en Ge après l'étape S11.

La deuxième couche 22 en Si peut être également formée par épitaxie sur la première couche 21. Son épaisseur est de préférence comprise entre 0,2 nm et 15 nm, de préférence entre 0,8 nm à 6 nm.

A l'étape S12 de la figure 2B, la couche d'oxyde de grille 15 du transistor est formée sur l'empilement 10, par exemple par oxydation thermique d'une portion au moins de la deuxième couche 22. L'oxydation thermique de la deuxième couche 22 en silicium permet d'obtenir facilement une couche d'oxyde de grille 15 constituée de dioxyde de silicium (SiO₂) et présentant une faible densité de défauts, autrement dit une couche d'oxyde de grille 15 de haute qualité. On peut considérer que la couche d'oxyde de grille 15 est de haute qualité lorsqu'elle présente une densité d'états d'interface Dᵢₜ inférieure à 2x10¹¹ /cm²/eV.

Une couche d'oxyde de grille de haute qualité empêche une dégradation de la mobilité des porteurs de charge dans la région de canal du transistor et conduit donc à de meilleures performances en courant.

L'oxydation thermique est réalisée en introduisant l'empilement 20 dans la chambre d'un four (par exemple constituée par un tube en quartz), en injectant dans la chambre un gaz contenant de l'oxygène (par exemple de dioxygène) et éventuellement un gaz neutre (tel que le diazote, N₂), puis en chauffant l'empilement 20 à une température comprise entre 400 °C et 1200°C, de préférence entre 400 °C et 500 °C.

Alternativement, la couche d'oxyde de grille 15 du transistor est formée par exposition de la deuxième couche 22 à un plasma contenant de l'oxygène, par exemple un plasma H₂O. Le plasma est de préférence formé (dans la chambre d'un réacteur) à une température inférieure ou égale à 500 °C.

Alternativement encore, la couche d'oxyde de grille 15 est formée par oxydation thermique à l'aide d'un recuit laser de type nanoseconde en présence d'oxygène (typiquement O₂).

Alternativement encore, la couche d'oxyde de grille 15 est formée par oxydation chimique, par exemple dans un bain HF + O₃ ou sous ammoniaque NH₄OH + H₂O₂.

Ces méthodes alternatives permettent également d'obtenir une couche d'oxyde de grille 15 de haute qualité.

Une épaisseur importante de la deuxième couche 22 en Si permet de réaliser une oxydation partielle de la deuxième couche 22, alors qu'avec une épaisseur faible, la deuxième couche 22 sera oxydée entièrement.

Une fois la couche d'oxyde 15 formée, cette dernière peut être soumise à un post traitement de nitruration, par exemple par un recuit sous NH₃ à 650°C en four, ou par un traitement nitrurant plasma dans la chambre d'un réacteur à une température inférieure ou égale à 500°C.

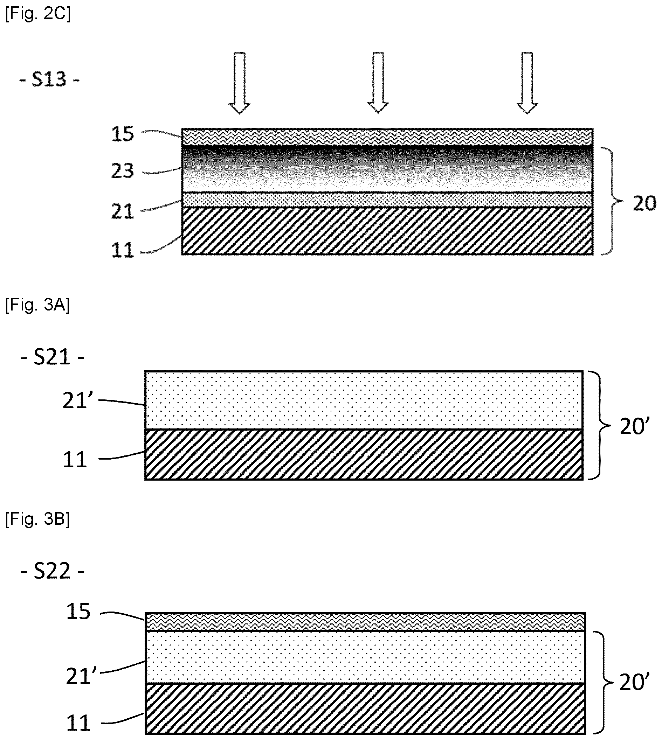

Enfin, à l'étape S13 de la figure 2C, l'empilement 20 est soumis à un recuit laser de manière à fondre une région de l'empilement 20, cette région comprenant une partie au moins de la deuxième couche 22 et une partie au moins de la première couche 21, et éventuellement une partie du substrat 11. Puis, en refroidissant, la région fondue de l'empilement 20 se recristallise pour former la couche active 23 comprenant un gradient de concentration en germanium.

Le gradient de concentration en germanium de la couche active 23 résulte d'une redistribution des atomes de germanium de la première couche 21 en SiGe, lors de la fusion et la recristallisation de la région de l'empilement 20. Les atomes de germanium sont concentrés dans la partie supérieure de l'empilement 20, à l'interface avec la couche d'oxyde de grille 15. Ainsi, les porteurs de charge électrique du transistor à effet de champ 10 bénéficieront d'une mobilité élevée dans la région de canal 12.

L'épaisseur de la région fondue peut varier en fonction de la concentration initiale en germanium de la première couche 21 et en fonction du gradient que l'on cherche à obtenir. Par exemple, si l'on souhaite obtenir une concentration d'environ 80 % à l'interface avec la couche d'oxyde de grille 15 et obtenir un gradient entre l'interface avec la couche d'oxyde de grille 15 et les dix premiers nanomètres de la première couche 21, alors que la première couche 21 présente une épaisseur de 30 nm avec une concentration de 40% en Ge, alors l'épaisseur de la région fondue sera d'environ 45 nm (correspondant à une densité d'énergie de 2,2 J/cm² pendant 160 ns et une longueur d'onde de 308 nm). L'épaisseur de la région fondue est avantageusement supérieure ou égale à 15 nm, afin de minimiser les défauts cristallins.

De préférence, la concentration initiale en germanium de la première couche 21 et l'épaisseur de la région fondue (en particulier dans la première couche 21) sont choisies de façon à obtenir une concentration maximale en germanium à l'interface avec la couche d'oxyde de grille 15 comprise entre 30 % et 80 %.

Le recuit laser est accompli en exposant la surface de la couche d'oxyde de grille 15 à un rayonnement émis par une source laser. Ainsi, le rayonnement laser traverse la couche d'oxyde de grille 15. Celle-ci n'est toutefois pas altérée par le rayonnement laser. Elle n'est ni fondue, ni endommagée.

Le rayonnement laser présente avantageusement une longueur d'onde comprise entre 200 nm et 600 nm (par exemple égale à 248 nm, 308 nm ou 532 nm) et une densité d'énergie comprise entre 0,1 J/cm² et 10 J/cm², de préférence entre 1,7 J/cm² et 2,5 J/cm². La durée d'exposition au rayonnement laser (pour chaque unité de surface de la couche d'oxyde de grille 15) peut être comprise entre 10 ns et 1000 ns (largeur à mi-hauteur de l'impulsion). On parle aussi de recuit laser nanoseconde (ou NLA, pour Nanosecond Laser Annealing » en anglais).

A titre d'exemple, le recuit laser est effectué au moyen d'un laser à gaz XeCl de longueur d'onde égale à 308 nm à une densité d'énergie comprise entre 1,7 et 3 J/cm² pendant une durée de 160 ns (largeur à mi-hauteur).

Lorsqu'une partie seulement de la première couche 21 est fondue, la couche active 23 se retrouve disposée entre la couche d'oxyde de grille 15 et la partie restante de la première couche 21.

La première couche 21 peut être totalement fondue lors du recuit laser. La couche active 23 s'étend alors du substrat 11 jusqu'à la couche d'oxyde de grille 15. Une partie du substrat 11 peut être également fondue.

Les figures 3A à 3C représentent des étapes S21 à S23 d'un procédé de fabrication du transistor à effet de champ 10, selon un deuxième mode de mise en œuvre non couvert par l'invention revendiquée. Ce deuxième mode de mise en œuvre diffère du premier mode de mise en œuvre uniquement dans la constitution de l'empilement de départ.

Ainsi, à l'étape S21 de la figure 3A, l'empilement 20' fourni comprend le substrat 11 et une couche de silicium-germanium 21' disposée sur le substrat 11. L'empilement 20' est dépourvu de la deuxième couche 22 en silicium. En outre, dans ce deuxième mode de mise en œuvre, la couche de SiGe 21' présente une concentration en Ge comprise entre 5 % et 10 %.

A l'étape S22 de la figure 3B, la couche d'oxyde de grille 15 est formée sur l'empilement 20', par oxydation thermique d'une partie au moins de la couche de SiGe 21' (plutôt que de la deuxième couche 22 en Si) ou par exposition de la couche de SiGe 21' à un plasma contenant de l'oxygène. La couche d'oxyde de grille 15 comprend essentiellement du dioxyde de silicium (elle est composée à plus de 90 % de SiO₂). Du fait de la faible concentration en germanium de la couche de SiGe 21', la couche d'oxyde de grille 15 contient une faible proportion d'oxyde de germanium (GeOₓ), typiquement inférieure ou égale à 10 %. La couche d'oxyde de grille 15 est alors d'une qualité supérieure à celle obtenue par le procédé de l'art antérieur et n'affecte pas les performances du transistor.

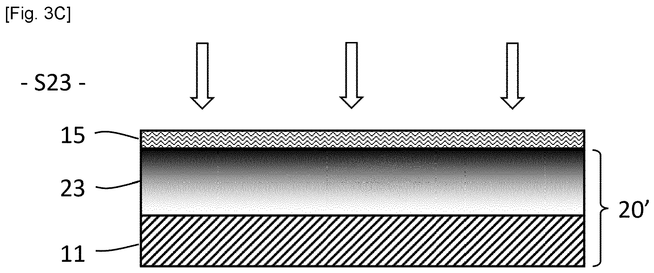

Enfin, à l'étape S23 de la figure 3C, une région de l'empilement 20' est fondue par recuit laser puis recristallisée pour former la couche active 23. La région de l'empilement 20' fondue par le laser comprend ici tout ou partie de la couche de SiGe 21', et éventuellement une partie du substrat 11. Le recuit laser est de préférence accompli de la façon décrite en relation avec la figure 2C. L'épaisseur de la région fondue est avantageusement supérieure ou égale à 15 nm, afin de minimiser les défauts cristallins.

De préférence, la concentration initiale en germanium de la couche de SiGe 21' et l'épaisseur de la région fondue (en particulier dans cette couche de SiGe 21') sont choisies de façon à obtenir une concentration maximale en germanium à l'interface avec la couche d'oxyde de grille 15 comprise entre 30 % et 80 %.

Le procédé de fabrication de transistor à effet de champ décrit ci-dessus en relation avec les figures 2A-2C ou 3A-3C permet d'obtenir une couche d'oxyde de grille 15 de haute qualité et une couche active 23 riche en germanium à l'interface avec la couche d'oxyde de grille 15. Il est en outre rapide et simple à mettre en œuvre.

La couche d'oxyde de grille 15 est de préférence formée à l'étape S12/22 d'une manière à présenter un pourcentage d'oxyde de germanium (GeOₓ) inférieur ou égal à 10 % et avantageusement nul.

Le recuit laser peut être accompli sous une atmosphère dépourvue d'oxygène, typiquement neutre (par exemple sous N₂), pour ne pas augmenter l'épaisseur de la couche d'oxyde de grille 15 déjà formée.

Dans une variante de mise en œuvre, la couche d'oxyde de grille 15 est formée lors de l'étape S13 ou S23 de recuit laser (et plus particulièrement lors de l'opération de fusion/recristallisation) en ajoutant de l'oxygène (typiquement O₂) à l'atmosphère du recuit. Autrement dit, les étapes S12/S22 et S13/S23 sont simultanées.

Le recuit laser peut être accompli au moyen d'une seule impulsion de rayonnement ou de plusieurs impulsions de rayonnement successives (reçues au même endroit). Ceci est valable pour les deux modes de mise en œuvre du procédé (étape S13 ou S23), avec ou sans formation simultanée de la couche d'oxyde de grille 15.

Après l'étape S12 (Fig.2B) ou S22 (Fig.3B) de formation de la couche d'oxyde de grille 15, le procédé de fabrication peut comporter une étape de dépôt d'une couche de matériau diélectrique « high-k » sur la couche d'oxyde de grille 15. Le matériau diélectrique « high-k » est par exemple de l'oxyde d'hafnium (HfO₂). L'épaisseur de la couche de matériau diélectrique « high-k » peut être comprise entre 0,5 nm et 5 nm, de préférence entre 2 nm et 3 nm.

La couche de matériau diélectrique « high-k » peut être déposée avant l'étape S13 ou S23 de recuit laser et de recristallisation de la couche active 23, dans la mesure où cette couche de matériau diélectrique « high-k » n'est pas affectée par le recuit laser (à l'instar de la couche d'oxyde de grille 15). La couche de matériau diélectrique « high-k » peut être aussi déposée après l'étape S13 ou S23 de recuit laser.

Le procédé de fabrication peut également comporter une étape de formation de l'électrode de grille 16 et une étape de formation des régions de drain et de source 13-14 après l'obtention de la couche active 23 (donc après le recuit laser). La manière dont sont accomplies ces étapes peut dépendre du type de transistor à effet de champ souhaité : transistor MOSFET à grille simple ou transistor MOSFET à grille multiple (FinFET, GAAFET), transistors sur substrat massif ou transistors de type silicium sur isolant partiellement ou complètement déplété (PDSOI, FDSOI).

Le procédé de fabrication du transistor à effet de champ 10 peut notamment comprendre les opérations suivantes :
- le dépôt d'au moins une couche en matériau électriquement conducteur (de préférence un métal ou du silicium polycristallin dopé) sur la couche d'oxyde de grille 15 (ou sur la couche de diélectrique « high-k », le cas échéant) ;
- la gravure de ladite au moins une couche en matériau électriquement conducteur, formant ainsi l'électrode de grille 16, de préférence avec arrêt de la gravure sur la couche d'oxyde de grille 15 (ou la couche de diélectrique « high-k ») ;
- la gravure de la couche d'oxyde de grille 15 (et de la couche de diélectrique « high-k », le cas échéant) en dehors de l'électrode de grille 16 ;
- la formation d'espaceurs en un ou plusieurs matériaux électriquement isolants ;
- une étape d'implantations de dopants de type P (bore (ex. ions BF₂⁺, ou en combinaison PAI (préamorphisation) avec du germanium), aluminium, gallium...) dans deux régions distinctes de la couche active 23 situées en dehors de l'empilement de grille (l'empilement de grille comprenant la couche d'oxyde de grille 15, l'éventuelle couche de diélectrique « high-k » et l'électrode de grille 16) pour former les régions de drain et de source 13-14, la portion non implantée de la couche active 23 formant alors la région de canal 12 du transistor 10.

Ces autres étapes de fabrication étant classiques, elles ne seront pas décrites plus en détail.

Le procédé de fabrication peut comprendre, plutôt que l'étape d'implantation ionique, une gravure de la couche active 23 et une étape d'épitaxie de silicium-germanium dopé ou de silicium dopé pour former les régions de drain et de source 13-14 (transistors FDSOI notamment). Il peut aussi comprendre une étape finale de recuit dit « de forming » visant à réduire la densité d'états d'interface (Dit), de préférence à une température inférieure ou égale à 500 °C.

Ce procédé de fabrication est particulièrement avantageux dans le cas d'une intégration 3D (séquentielle ou monolithique) de transistors à effet de champ, car le recuit laser nanoseconde n'endommage pas les transistors précédemment formés (respect du budget thermique de ces transistors).

## Revendications

1. Procédé de fabrication d'un transistor à effet de champ (10) comprenant une couche active (23) en silicium-germanium et une couche d'oxyde de grille (15) disposée sur la couche active (23), le procédé comprenant les étapes suivantes :
- fournir (S11) un empilement (20) comprenant un substrat (11), une première couche (21) en silicium-germanium disposée sur le substrat (11) et une deuxième couche (22) en silicium disposée sur la première couche (21) ;
- former (S12) la couche d'oxyde de grille (15) sur l'empilement (20) ;
- soumettre (S13) l'empilement (20) à un recuit laser de manière à fondre une région de l'empilement, ladite région comprenant une partie au moins de la première couche (21) et une partie au moins de la deuxième couche (22), et recristalliser (S13) la région fondue de l'empilement (20) pour obtenir la couche active (23) en silicium-germanium en contact avec la couche d'oxyde de grille (15), la couche active (23) présentant un gradient de concentration en germanium ;
procédé dans lequel la couche d'oxyde de grille (15) est formée avant l'étape (S13) de recuit laser ou pendant l'étape (S13) de recuit laser.

2. Procédé selon la revendication 1, dans lequel la couche d'oxyde de grille (15) est formée par oxydation thermique ou chimique d'une portion au moins de la deuxième couche (22) ou par exposition de la deuxième couche (22) à un plasma contenant de l'oxygène.

3. Procédé selon l'une des revendications 1 et 2, dans lequel la deuxième couche (22) en silicium présente une épaisseur comprise entre 0,2 nm et 15 nm, de préférence entre 0,8 nm et 6 nm.

4. Procédé selon l'une quelconque des revendications 1 à 3, dans lequel la couche d'oxyde de grille (15) est constituée de dioxyde de silicium et présente une épaisseur comprise entre 0,5 nm et 6 nm.

5. Procédé selon l'une quelconque des revendications 1 à 4, dans lequel la première couche (21) en silicium-germanium présente une concentration en germanium comprise entre 1 % et 80 %, préférentiellement entre 10 % et 60 %.

6. Procédé selon l'une quelconque des revendications 1 à 5, comprenant en outre une étape de dépôt d'une couche de matériau diélectrique à constante diélectrique élevée sur la couche d'oxyde de grille (15).

7. Procédé selon la revendication 6, dans lequel la couche de matériau diélectrique à constante diélectrique élevée est formée avant l'étape (S13) de recuit laser.

8. Procédé selon l'une quelconque des revendications 1 à 7, dans lequel le recuit laser est accompli en exposant l'empilement à un rayonnement laser présentant une longueur d'onde comprise entre 200 nm et 600 nm et une densité d'énergie comprise entre 0,1 J/cm² et 10 J/cm² pendant une durée comprise entre 10 ns et 1000 ns.

9. Procédé selon l'une quelconque des revendications 1 à 8, dans lequel le recuit laser est accompli sous une atmosphère dépourvue d'oxygène.

10. Procédé selon l'une quelconque des revendications 1 à 8, dans lequel le recuit laser est accompli sous une atmosphère contenant de l'oxygène pour former simultanément la couche d'oxyde de grille (15).

11. Procédé selon l'une quelconque des revendications 1 à 10, comprenant en outre une étape de formation d'une électrode de grille sur la couche d'oxyde de grille et une étape de formation de régions de source et de drain.

## Patentansprüche

1. Verfahren zur Herstellung eines Feldeffekttransistors (10) mit einer aktiven Schicht (23) aus Silizium-Germanium und einer auf der aktiven Schicht (23) angeordneten Gateoxidschicht (15), wobei das Verfahren die folgenden Schritte umfasst:
- Bereitstellen (S11) eines Stapels (20), der ein Substrat (11), eine erste Schicht (21) aus Silizium-Germanium, die auf dem Substrat (11) angeordnet ist, und eine zweite Schicht (22) aus Silizium, die auf der ersten Schicht (21) angeordnet ist, umfasst;
- Bilden (S12) der Gateoxidschicht (15) auf dem Stapel (20)
- Unterziehen (S13) des Stapels (20) einer Lasertemperung, um einen Bereich des Stapels zu schmelzen, wobei der Bereich mindestens einen Teil der ersten Schicht (21) und mindestens einen Teil der zweiten Schicht (22) umfasst, und Rekristallisieren (S13) des geschmolzenen Bereichs des Stapels (20), um die aktive Schicht (23) aus Silizium-Germanium in Kontakt mit der Gateoxidschicht (15) zu erhalten, wobei die aktive Schicht (23) einen Germaniumkonzentrationsgradienten aufweist;
wobei die Gateoxidschicht (15) vor dem Lasertemperungsschritt (S13) oder während des Lasertemperungsschritts (S13) gebildet wird.

2. Verfahren nach Anspruch 1, bei dem die Gateoxidschicht (15) durch thermische oder chemische Oxidation mindestens eines Teils der zweiten Schicht (22) oder durch Eintauchen der zweiten Schicht (22) in ein sauerstoffhaltiges Plasma gebildet wird.

3. Verfahren nach einem der Ansprüche 1 und 2, bei dem die zweite Schicht (22) aus Silizium eine Dicke zwischen 0,2 nm und 15 nm, vorzugsweise zwischen 0,8 nm und 6 nm aufweist.

4. Verfahren nach einem der Ansprüche 1 bis 3, bei dem die Gateoxidschicht (15) aus Siliziumdioxid besteht und eine Dicke zwischen 0,5 nm und 6 nm aufweist.

5. Verfahren nach einem der Ansprüche 1 bis 4, bei dem die erste Schicht (21) aus Silizium-Germanium eine Germaniumkonzentration zwischen 1 % und 80 %, vorzugsweise zwischen 10 % und 60 % aufweist.

6. Verfahren nach einem der Ansprüche 1 bis 5, das zusätzlich einen Schritt zum Aufbringen einer Schicht aus einem dielektrischen Material mit hoher Dielektrizitätskonstante auf die Gateoxidschicht (15) umfasst.

7. Verfahren nach Anspruch 6, bei dem die Schicht aus dielektrischem Material mit hoher Dielektrizitätskonstante vor dem Schritt (S13) des Lasertemperns gebildet wird.

8. Verfahren nach einem der Ansprüche 1 bis 7, bei dem das Lasertempern durchgeführt wird, indem der Stapel einer Laserstrahlung mit einer Wellenlänge zwischen 200 nm und 600 nm und einer Energiedichte zwischen 0,1 J/cm² und 10 J/cm² für eine Dauer zwischen 10 ns und 1000 ns ausgesetzt wird.

9. Verfahren nach einem der Ansprüche 1 bis 8, bei dem das Lasertempern in einer sauerstofffreien Atmosphäre durchgeführt wird.

10. Verfahren nach einem der Ansprüche 1 bis 8, bei dem das Lasertempern in einer sauerstoffhaltigen Atmosphäre durchgeführt wird, um gleichzeitig die Gateoxidschicht (15) zu bilden.

11. Verfahren nach einem der Ansprüche 1 bis 10, das ferner einen Schritt zum Bilden einer Gateelektrode auf der Gateoxidschicht und einen Schritt zum Bilden von Source- und Drain-Bereichen umfasst.

## Claims

1. Method for manufacturing a field effect transistor (10) comprising a silicon-germanium active layer (23) and a gate oxide layer (15) disposed on the active layer (23), the method comprising the following steps of:
- providing (S11) a stack (20) comprising a substrate (11), a silicon-germanium first layer (21) disposed on the substrate (11) and a silicon second layer (22) disposed on the first layer (21);
- forming (S12) the gate oxide layer (15) on the stack (20);
- subjecting (S13) the stack (20) to laser annealing so as to melt a region of the stack, said region comprising at least one part of the first layer (21) and at least one part of the second layer (22), and recrystallising (S13) the molten region of the stack (20) to obtain the silicon-germanium active layer (23) in contact with the gate oxide layer (15), the active layer (23) having a germanium concentration gradient;
in which method the gate oxide layer (15) is formed before the laser annealing step (S13) or during the laser annealing step (S13).

2. Method according to claim 1, wherein the gate oxide layer (15) is formed by thermally or chemically oxidising at least one portion of the second layer (22) or by exposing the second layer (22) to an oxygen-containing plasma.

3. Method according to one of claims 1 to 2, wherein the silicon second layer (22) has a thickness of between 0.2 nm and 15 nm, preferably between 0.8 nm and 6 nm.

4. Method according to any of claims 1 to 3, wherein the gate oxide layer (15) consists of silicon dioxide and has a thickness of between 0.5 nm and 6 nm.

5. Method according to any of claims 1 to 4, wherein the silicon-germanium first layer (21) has a germanium concentration of between 1% and 80%, preferably between 10% and 60%.

6. Method according to any of claims 1 to 5, further comprising a step of depositing a layer of high dielectric constant dielectric material onto the gate oxide layer (15).

7. Method according to claim 6, wherein the layer of high dielectric constant dielectric material is formed before the laser annealing step (S13).

8. Method according to any of claims 1 to 7, wherein the laser annealing is performed by exposing the stack to laser radiation having a wavelength between 200 nm and 600 nm and an energy density between 0.1 J/cm² and 10 J/cm² for a duration between 10 ns and 1000 ns.

9. Method according to any of claims 1 to 8, wherein the laser annealing is performed in an oxygen-devoid atmosphere.

10. Method according to any of claims 1 to 8, wherein the laser annealing is performed in an oxygen-containing atmosphere to simultaneously form the gate oxide layer (15).

11. Method according to any of claims 1 to 10, further comprising a step of forming a gate electrode on the gate oxide layer and a step of forming source and drain regions.
